# EUROPÄISCHE PATENTANMELDUNG

(11) **EP 2 287 900 A1**
(43) Veröffentlichungstag der Anmeldung: **23.02.2011**
(21) Anmeldenummer: 10450130.9
(22) Anmeldetag: 09.08.2010
(51) Int. Cl.: H01L 21/687

(54) **Träger für Wafer**

(30) Priorität: 20.08.2009 AT 5232009 U
(71) Anmelder: Aichholzer, Johann, 9020 Klagenfurt (AT)
(72) Erfinder: Aichholzer, Johann, 9020 Klagenfurt (AT)
(74) Vertreter: Beer, Manfred

(57) **Zusammenfassung**

Bei einem Träger (1) für einen Wafer (8) ist an der Oberseite der Scheibe (2) des Trägers (1) eine Platte (6) aus Keramik aufgelegt, die mit einer nach oben abstehenden, ringförmigen Erhöhung (7) den Bereich definiert, in welchen ein Wafer (8) aufzulegen ist. Zum Auflegen und Abheben des Wafers (8) von der Platte (6) sind Hebestifte (12) vorgesehen, die in Hülsen (11) des Trägers (1) verschiebbar sind. Um zu verhindern, dass die Platte (6) an der Oberseite (5) des Trägers (1) abgehoben wird und um zu verhindern, dass Prozessmedien zwischen die Scheibe (2) des Trägers (1) und die Platte (6) eindringen können, sind die Hülsen (6), in welchen die Hebestifte (12) geführt sind, mit der Platte (6) verbunden, sodass diese stets in dichter Anlage an der Scheibe (2) des Trägers (1) gehalten ist.

## Beschreibung

Die Erfindung betrifft einen Träger für einen scheibenförmigen Gegenstand, insbesondere einen Wafer (Siliziumwafer), mit einer von einer Platte, insbesondere einer Platte aus Keramik, gebildeten Auflagefläche für den Gegenstand und mit aus der Auflagefläche zum Anheben des Gegenstandes ausfahrbaren Hebestiften, die in Hülsen, die in den Träger eingesetzt sind, geführt sind.

Derartige Träger für Wafer sind bekannt.

In bestimmten Bearbeitungsschritten von Wafern mit dem Ziel, aus diesen Halbleiter herzustellen, ist es erforderlich, den Wafer mit gasförmigen oder flüssigen Medien zu bearbeiten und gegebenenfalls zu erwärmen. Hiezu ist es bekannt, den auf einen Träger (Chuck), der insbesondere aus Keramik oder Metall besteht, aufgelegten Wafer zu erwärmen. Das Erwärmen kann so erfolgen, dass Wärme über eine auf den eigentlichen Träger aufgelegte Platte aus Keramik auf den Wafer übertragen wird.

In bekannten Ausführungsformen besitzt die auf dem Träger aufgelegte Platte vier Öffnungen, aus denen Hebestifte (lifting pins) aus Keramik vorschiebbar sind, um den Wafer von der Platte abzuheben, sodass der Wafer, nachdem er behandelt worden ist, mit Hilfe von Greifern oder Löffeln abgenommen und wegbewegt werden kann.

Auch beim Auflegen von Wafern auf den Träger kann, um das Wegbewegen der Greifer oder Löffel zu ermöglichen, der Wafer zunächst auf die ausgefahrenen Hebestifte aufgelegt und erst dann, nachdem der Greifer oder der Löffel wegbewegt worden ist, durch Einfahren der Hebestifte auf die auf den Träger aufgelegte Platte abgelegt werden.

Die Hebestifte sind in Hülsen aus Keramik geführt, die im Träger befestigt, insbesondere eingepresst, sind.

Das in den Löchern in der Platte des Trägers liegende Ende der Hebestifte ist sich kegelstumpfartig erweiternd ausgebildet und passt genau in das gegengleich konische, obere Ende der Öffnung in der Platte.

Um einen guten Wärmeübergang von dem Träger auf die Platte zu erreichen, soll die Platte plan und ohne Zwischenräume auf dem Träger aufliegen. Verunreinigungen zwischen der Platte und der Oberseite des Trägers behindern den Wärmeübergang. Durch einen Abstand zwischen Platte und Träger kann die obere Seite des Trägers beschädigt werden, sodass ein guter Wärmeübergang vom Träger zur Platte behindert ist. Es kann vorkommen, dass die Platte beim Ausfahren der Hebestifte mitbewegt wird, sodass in den Raum zwischen Platte und Oberseite des Trägers die oben erwähnten Verunreini-gungen eindringen können.

Der Erfindung liegt die Aufgabe zu Grunde, einen Träger der eingangs genannten Gattung zur Verfügung zu stellen, welcher die geschilderten Nachteile nicht aufweist.

Gelöst wird diese Aufgabe erfindungsgemäß mit einem Träger, welcher die Merkmale von Anspruch 1 aufweist.

Bevorzugte und vorteilhafte Ausgestaltungen des erfindungsgemäßen Trägers sind Gegenstand der Unteransprüche.

Da bei dem erfindungsgemäßen Träger die Platte mit den im Träger vorgesehenen (und mit diesem fix verbundenen) Hülsen verbunden ist, besteht die Gefahr, dass die Platte nicht exakt aufliegt bzw. beim Ausfahren der Hebestifte von der Oberseite des Trägers abgehoben wird, nicht. Somit ist auch die Gefahr von Verunreinigungen beseitigt. Auch ist die Gefahr, dass flüssige/gasförmige, den Wafer behandelnde Medien zwischen die Platte, die insbesondere aus Keramik besteht, und die Oberseite des Trägers eindringen, beseitigt, da die Platte durch die im Träger festgelegten Stifte gehalten wird und in dichter Anlage an der Oberseite des Trägers bleibt.

Durch die erfindungsgemäße Maßnahme ist gewährleistet, dass die Platte an der Oberseite des Trägers durch die im Träger befestigten Hülsen, die mit der Platte verbunden sind (integrierte Hülsen), gut auf dem Träger aufliegt und der Raum zwischen der Oberseite des Trägers und der Unterseite der Platte geschlossen ist.

Durch die erfindungsgemäßen Maßnahmen wird auch verhindert, dass Verunreinigungen und/oder Prozessmedien in der Nähe der Öffnungen für die Hebestifte durch den Spalt zwischen Träger, Platte und Hülse eindringen, den Werkstoff (z.B. Metall) des Trägers angreifen und diesen an der Oberfläche beschädigen.

In einer Ausführungsform der Erfindung kann vorgesehen sein, dass die Hülsen mit der Platte einteilig ausgebildet sind.

In einer Ausführungsform der Erfindung kann vorgesehen sein, dass die Hülsen mit der Platte verschraubt sind.

In einer Ausführungsform der Erfindung kann vorgesehen sein, dass an der dem Träger zugekehrten Seite der Platte Vorsprünge vorgesehen sind, über welche die Hülsen mit der Platte verbunden, insbesondere verschraubt, sind.

In einer Ausführungsform der Erfindung kann vorgesehen sein, dass die Platte an ihrem Außenrand einen Ring aufweist.

In einer Ausführungsform der Erfindung kann vorgesehen sein, dass der Ring die seitliche Außenfläche des Trägers, insbesondere von dessen Scheibe, übergreift.

In einer Ausführungsform der Erfindung kann vorgesehen sein, dass zwischen der Außenfläche des Trägers, insbesondere dessen Scheibe, und der Innenfläche des Ringes Spiel vorliegt.

In einer Ausführungsform der Erfindung kann vorgesehen sein, dass dem Träger eine Einrichtung zum Erwärmen des Trägers zugeordnet ist.

In einer Ausführungsform der Erfindung kann vorgesehen sein, dass die Einrichtung zum Erwärmen des Trägers in den Träger integriert ist.

In einer Ausführungsform der Erfindung kann vorgesehen sein, dass die Hülsen aus Keramik bestehen.

In einer Ausführungsform der Erfindung kann vorgesehen sein, dass die Hebestifte durch einen gemeinsamen Antrieb, insbesondere einen Hubring, ausfahrbar sind.

In einer Ausführungsform der Erfindung kann vorgesehen sein, dass die Hebestifte aus Keramik bestehen.

In einer Ausführungsform der Erfindung kann vorgesehen sein, dass die Einrichtung zum Erwärmen des Trägers eine in den Träger integrierte Widerstandsheizung ist.

In einer Ausführungsform der Erfindung kann vorgesehen sein, dass der Träger für eine induktive Einrichtung zum Erwärmen wenigstens teilweise aus induktiv leitfähigem Werkstoff besteht.

In einer Ausführungsform der Erfindung kann vorgesehen sein, dass an der Oberseite der Platte wenigstens eine Erhöhung vorgesehen ist, die den Bereich, in dem ein Gegenstand auf den Träger aufzulegen ist, umgrenzt.

Weitere Einzelheiten und Merkmale der Erfindung ergeben sich aus der nachstehenden Beschreibung bevorzugter Ausführungsbeispiele unter Bezugnahme auf die Zeichnungen.

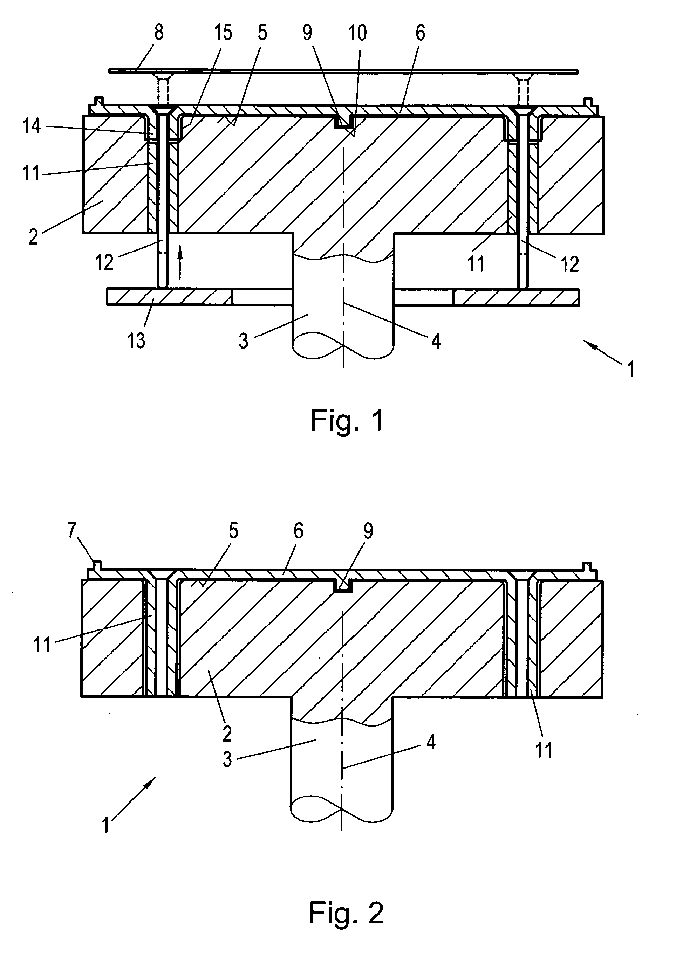

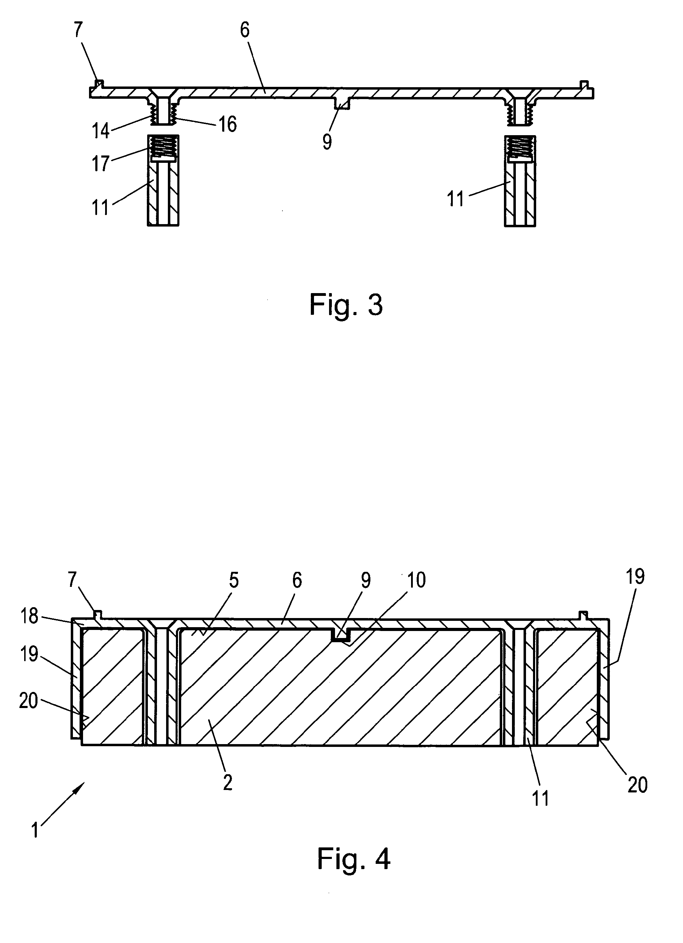

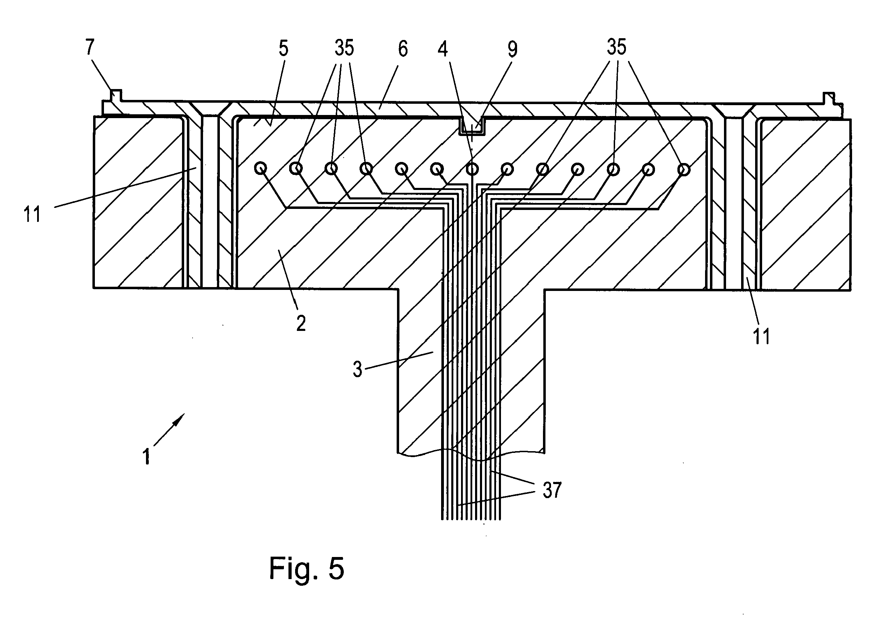

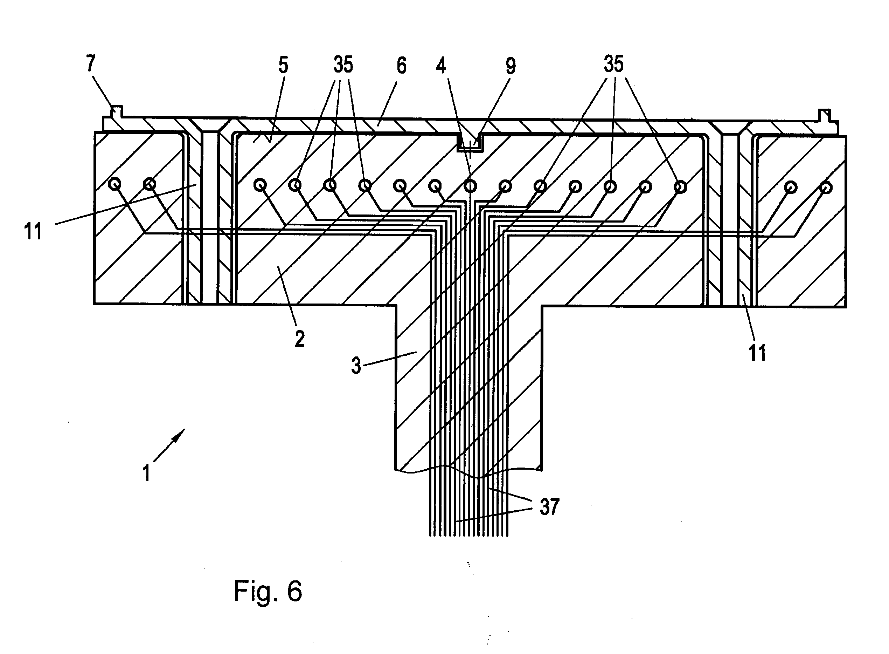

Es zeigt: Fig. 1 schematisch und im Schnitt einen Träger des Standes der Technik, Fig. 2 einen erfindungsgemäßen Träger ohne Hebestifte, Fig. 3 eine Keramikplatte mit Hülsen (zerlegt), Fig. 4 eine abgeänderte Ausführungsform eines Trägers, Fig. 5 eine Ausführungs-form mit Heizung im Träger und Fig. 6 eine andere Ausführungsform mit Heizung im Träger. Ein in Fig. 1 gezeigter, bekannter Träger 1 besteht aus einer in der Regel kreisrunden Scheibe 2 aus Metall, die über eine Welle 3 gehalten und gegebenenfalls um ihre Achse 4 in Drehung versetzt werden kann.

An der Oberseite 5 der Scheibe 2 des Trägers 1 liegt eine Platte 6 auf, die in der Regel aus Keramik besteht. An der Oberseite der Platte 6 ist ein ringförmiger Vorsprung 7 (oder mehrere ringsherum angeordnete Vorsprünge) als Erhöhung vorgesehen, die den Bereich begrenzt, in dem ein Wafer 8 auf den Träger 1, genauer dessen Platte 6, aufzulegen ist. Zur exakten Führung der Platte 6 gegenüber der Platte 2 des Trägers 1 ist in ihrer Mitte ein nach unten weisender Vorsprung 9 vorgesehen, der in eine zur Oberseite 5 der Scheibe 2 des Trägers 1 hin offene Öffnung 10 (Vertiefung) eingreift.

In der Scheibe 2 des Trägers 1 sind in achsparallelen Bohrungen Hülsen 11, die insbesondere aus Keramik bestehen, festgelegt, z.B. eingepresst. In den Hülsen 11 sind Hebestifte 12, die ebenfalls aus Keramik bestehen, verschiebbar aufgenommen. Zum Betätigen der Hebestifte 12, um diese aus der in Fig. 1 in vollen Linien eingezeichneten Bereitschaftslage in die Wirklage, die in Fig. 1 strichliert eingezeichnet ist, auszufahren, ist unterhalb der Scheibe 2 des Trägers 1 ein Hubring 13 vorgesehen, der an allen (in der Regel vier) Hebestiften 12 von unten her angreift, um diese auszufahren bzw. abzusenken.

Die oberen Enden der Hebestifte 12, die in ihrer Wirklage gegenüber der Platte 6 angehoben sind, sind sich konisch erweiternd ausgebildet und in der Bereitschaftslage in entsprechend versenkten Öffnungen der Platte 6 aufgenommen. Die Platte 6 liegt wie im Stand der Technik bekannt, lose auf der Scheibe 2 auf und greift mit nach unten weisenden Vorsprüngen 14 in Vertiefungen 15 der Scheibe 2 des Trägers 1 ein.

Bei der in Fig. 2 gezeigten Ausführungsform eines erfindungsgemäßen Trägers 1 ist die Platte 6 mit den Hülsen 7, die in der Scheibe 2 des Trägers 1 festgelegt sind, einstückig ausgebildet. So ist gewährleistet, dass die Platte 6 beim Ausfahren der Hebestifte 12 (in Fig. 2 nicht dargestellt) von der Oberseite 5 der Scheibe 2 des Trägers 1 nicht abgehoben werden kann.

In Fig. 3 ist eine alternative Ausführungsform der Verbindung zwischen Platte 6 und Hülsen 11 dargestellt. Bei dieser Ausführungsform sind an den nach unten weisenden Vorsprüngen 14 der Trägerplatte 6 Außengewinde 16 vorgesehen. In den oberen, der Platte 6 zugekehrten, Enden der Hülsen 11 sind Abschnitte mit Innengewinde 17 vorgesehen. So können die Hülsen 11 mit der Platte 6 über deren Vorsprünge 14 verschraubt werden, um sie mit der Platte 6 fix zu verbinden.

Fig. 4 zeigt eine Abwandlung der in Fig. 2 gezeigten Ausführungsform, wobei der Träger 1 ohne Welle 3 an der Scheibe 2 ausgebildet ist. Die Platte 6 aus Keramik ist auch im Ausführungsbeispiel von Fig. 4 entweder mit den Hülsen 11 einstückig ausgebildet oder die Hülsen 11 sind - wie bei der Ausführungsform von Fig. 3 - mit der Platte 6 verschraubt. Bei der in Fig. 4 gezeigten Ausführungsform ist die Platte 6 zusätzlich dadurch gesichert, dass sie an ihrem Umfangsrand 18 mit einem Ring 19 versehen ist, der mit der Platte 6 insbesondere einstückig ausgebildet ist, und der sich an der äußeren Seitenfläche 20 der Scheibe 2 des Trägers 1 diese überdeckend anlegt. So ist der Träger 1 auch seitlich geschützt und das Eindringen von Prozessmedium zwischen Platte 6 und Scheibe 2 des Trägers 1 ist zusätzlich verhindert. Der Ring 19 kann mit der Platte 6 aus keramischem Werkstoff einstückig ausgebildet sein. In einer bevorzugten Ausführungsform ist zwischen der äußeren Seitenfläche 20 der Scheibe 2 des Trägers 1 und der Innenfläche des Ringes 19 Spiel vorgesehen, um unterschiedlichen thermischen Ausdehnungskoeffizienten des Werkstoffes der Scheibe 2 und des Ringes 19 Rechnung zu tragen

Die Scheibe 2 des Trägers 1 kann mit einer Einrichtung zum Erwärmen des Trägers versehen sein, wenn nicht das Erwärmen der Platte 6 oder eines Wafers 8 durch andere Mittel, wie Strahler oder Heizlampen, erfolgt.

Wenn in dem Träger 1 eine Einrichtung zum Erwärmen desselben und damit der Platte 6 sowie des Wafers 8 vorgesehen ist, kann diese Heizeinrichtung eine in den Träger 1 integrierte Widerstandsheizung sein oder es ist eine induktive Einrichtung vorgesehen, wobei der Träger 1, insbesondere dessen Scheibe 2, wenigstens teilweise aus induktiv leitfähigem Werkstoff besteht. Ein Beispiel für eine in eine Scheibe 2 integrierte Heizung ist in Fig. 5 gezeigt. Bei der in Fig. 5 gezeigten Ausführungsform des Trägers 1, der über eine Welle 3 in einer Vakuumkammer angeordnet ist, ist in der Scheibe 2 des Trägers 1 eine elektrische Widerstandsheizung 35 vorgesehen. Bei dem in Fig. 5 gezeigten Ausführungsbeispiel besteht der Träger 1 aus Metall und es sind über seine Welle 3 elektrische Leitungen 37 geführt, die die elektrische Widerstandsheizung 35 im Träger 1 mit elektrischer Energie versorgen, um den Träger 1 zu erwärmen. Da bei der in Fig. gezeigten Ausführungsform der Träger 1 für den Wafer mit einer Einrichtung zum Erwärmen ausgestattet ist, ist es nicht mehr erforderlich, den Träger 1 durch Zuführen von Strahlungswärme, die von einer externen Quelle kommt, zu erwärmen.

Bei der in Fig. 5 gezeigten Ausführungsform ist die Widerstandsheizung 35 innerhalb der Hülsen 11 für die Hebestifte 12 angeordnet, wogegen bei der in Fig. 6 gezeigten Ausführungsform die Widerstandsheizung 35 auch außerhalb der Hülsen 11 für die Hebestifte 12 vorgesehen ist.

Dies hat den Vorteil, dass die Kosten an Material, Energie und Wartung verringert werden.

Eine Heizung, wie sie vorstehend und im Zusammenhang mit Fig. 5 und Fig. 6 beschrieben worden ist, kann auch bei den anderen Fig. 2 bis 4 gezeigten Ausführungsformen vorgesehen sein.

Zusammenfassend kann ein Ausführungsbeispiel der Erfindung wie folgt beschrieben werden:

Bei einem Träger 1 für einen Wafer 8 ist an der Oberseite der Scheibe 2 des Trägers 1 eine Platte 6 aufgelegt, die mit einer nach oben abstehenden, ringförmigen Erhöhung 7 den Bereich definiert, in welchen ein Wafer 8 aufzulegen ist. Zum Auflegen und Abheben des Wafers 8 von der Platte 6 sind Hebestifte 12 vorgesehen, die in Hülsen 11 des Trägers 1 verschiebbar sind. Um zu verhindern, dass die Platte 6 an der Oberseite 5 des Trägers 1 abgehoben wird und um zu verhindern, dass Prozessmedien zwischen die Scheibe 2 des Trägers 1 und die Platte 6 eindringen können, sind die Hülsen 6, in welchen die Hebestifte 12 geführt sind, mit der Platte 6 verbunden, sodass diese stets in dichter Anlage an der Scheibe 2 des Trägers 1 gehalten ist.

## Patentansprüche

1. Träger (1) für einen scheibenförmigen Gegenstand (8), insbesondere einen Wafer (Siliziumwafer), mit einer von einer Platte (6), insbesondere einer Platte (6) aus Keramik, gebildeten Auflagefläche für den Gegenstand (8) und mit aus der Auflagefläche zum Anheben des Gegenstandes (8) ausfahrbaren Hebestiften (12), die in Hülsen (11), die in den Träger (1) eingesetzt sind, geführt sind, **dadurch gekennzeichnet, dass** die Platte (6) mit den Hülsen (11) verbunden ist.

2. Träger nach Anspruch 1, **dadurch gekennzeichnet, dass** die Hülsen (11) mit der Platte (6) einteilig ausgebildet sind.

3. Träger nach Anspruch 1, **dadurch gekennzeichnet, dass** die Hülsen (11) mit der Platte (6) verschraubt sind.

4. Träger nach Anspruch 1 oder 3, **dadurch gekennzeichnet, dass** an der dem Träger (1) zugekehrten Seite der Platte (6) Vorsprünge (14) vorgesehen sind, über welche die Hülsen (11) mit der Platte (6) verbunden, insbesondere verschraubt, sind.

5. Träger nach einem der Ansprüche 1 bis 4, **dadurch gekennzeichnet, dass** die Platte (6) an ihrem Außenrand (18) einen Ring (19) aufweist.

6. Träger nach Anspruch 5, **dadurch gekennzeichnet, dass** der Ring (19) die seitliche Außenfläche (20) des Trägers (1), insbesondere von dessen Scheibe (2), übergreift.

7. Träger nach Anspruch 6, **dadurch gekennzeichnet, dass** zwischen der Umfangsfläche (20) des Trägers (1), insbesondere dessen Scheibe (2), und der Innenfläche des Ringes (19) Spiel vorliegt.

8. Träger nach einem der Ansprüche 1 bis 7, **dadurch gekennzeichnet, dass** dem Träger (1) eine Einrichtung zum Erwärmen des Trägers (1) zugeordnet ist.

9. Träger nach Anspruch 8, **dadurch gekennzeichnet, dass** die Einrichtung zum Erwärmen des Trägers (1) in den Träger integriert ist.

10. Träger nach einem der Ansprüche 1 bis 9, **dadurch gekennzeichnet, dass** die Hülsen (11) aus Keramik bestehen.

11. Träger nach einem der Ansprüche 1 bis 10, **dadurch gekennzeichnet, dass** die Hebestifte (12) durch einen gemeinsamen Antrieb (13), insbesondere einen Hubring (13), ausfahrbar sind.

12. Träger nach einem der Ansprüche 1 bis 11, **dadurch gekennzeichnet, dass** die Hebestifte (12) aus Keramik bestehen.

13. Träger nach einem der Ansprüche 1 bis 12, **dadurch gekennzeichnet, dass** die Einrichtung zum Erwärmen des Trägers (1) eine in den Träger (1) integrierte Widerstandsheizung ist.

14. Träger nach einem der Ansprüche 1 bis 13, **dadurch gekennzeichnet, dass** der Träger (1) für eine induktive Einrichtung zum Erwärmen wenigstens teilweise aus induktiv leitfähigem Werkstoff besteht.

15. Träger nach einem der Ansprüche 1 bis 14, **dadurch gekennzeichnet, dass** an der Oberseite der Platte (6) wenigstens eine Erhöhung (7) vorgesehen ist, die den Bereich, in dem ein Gegenstand (8) auf den Träger (1) aufzulegen ist, umgrenzt.
